# EUROPÄISCHE PATENTSCHRIFT

(11) **EP 2 559 123 B1**
(45) Veröffentlichungstag und Bekanntmachung des Hinweises auf die Patenterteilung: **07.09.2016**
(21) Anmeldenummer: 11716199.2
(22) Anmeldetag: 13.04.2011
(51) Int. Cl.: H02J 3/18, H05K 7/14, H02B 1/48

(54) **MODULANORDNUNG ZUM ANWENDUNGSSPEZIFISCHEN AUFBAU VON BLINDLEISTUNGS-KOMPENSATIONS-, FILTER- UND SAUGKREISANLAGEN**
MODULE ASSEMBLY FOR THE APPLICATION-SPECIFIC CONSTRUCTION OF POWER FACTOR CORRECTION SYSTEMS, FILTER SYSTEMS, AND ABSORPTION CIRCUIT SYSTEMS
AGENCEMENT MODULAIRE POUR CONSTITUER, EN FONCTION DES APPLICATIONS, DES SYSTÈMES DE COMPENSATION DE PUISSANCE RÉACTIVE, DES SYSTÈMES DE FILTRE ET DES SYSTÈMES DE CIRCUIT D'ABSORPTION

(30) Priorität: 15.04.2010 DE 102010015100
(43) Veröffentlichungstag der Anmeldung: 20.02.2013
(73) Patentinhaber: System Electric GmbH, 63589 Linsengericht-Altenhasslau (DE)
(72) Erfinder: HOLBE, Klaus, 87538 Obermaiselstein (DE)
(74) Vertreter: Kruspig, Volkmar
(86) Internationale Anmeldenummer: PCT/EP2011/055797
(87) Internationale Veröffentlichungsnummer: WO 2011/141259

(56) Entgegenhaltungen:
- CN-A- 101 557 081
- CN-Y- 2 847 611
- CN-Y- 201 365 073
- DE-A1- 4 208 612
- US-A- 5 541 808

## Beschreibung

Die Erfindung betrifft eine Modulanordnung zum anwendungsspezifischen Aufbau von Blindleistungs-Kompensations-Filter- und Saugkreisanlagen in wahlweiser unverdrosselter, verdrosselter, Schütz- oder Thyristor-geschalteter Ausführung, umfassend ein Sammelschienen-System, Sicherungshalter, Schaltgeräte, mindestens eine Drossel und Leistungskondensatoren gemäß Patentanspruch 1.

Blindleistungskompensationsanlagen in unverdrosselter oder verdrosselter Ausführung gehören zum Stand der Technik. Derartige Anlagen werden üblicherweise anschlussfertig zur zentralen Kompensation der Blindleistung in Niederspannungs- Drehstromnetzen mit geringfügiger oder erhöhter Oberschwingungsbelastung eingesetzt. Diese Anlagen umfassen in der Regel, ein Sammelschienensystem mit Sammelschienenträgern und NH-Reitersicherungselementen, Schaltgeräte, Drosseln und verlustarme, selbstheilende Kondensatoren mit Überdrucksicherung.

Diese Einzelelemente werden auf Stahlblechträgerplatten zu Einheiten von 25 - 150 Kvar zusammengebaut. Üblicherweise werden dann je nach Leistung 1 - 6 solcher Einheiten, zusammen mit einem Blindleistungs-Regler in Stahlblech- oder Isolierstoffschränken montiert, wie offenbart in DE 42 08 612 A1.

Durch die notwendige Montage von Sammelschienenträgern, Sammelschienen, Sicherungselementen, diskreten Schaltgeräten, Filterkreisdrosseln und einer größeren Anzahl von Kondensatoren sowie der notwendigen Chassis, sind das Gesamtgewicht und die Abmessungen solcher Kompensationsmodule und daraus gebauter Anlagen erheblich. Weiterhin entsteht durch die erforderliche Einzelmontage und die diskrete Verdrahtung ein hoher Montageaufwand.

Aus dem Vorgenannten ist es daher Aufgabe der Erfindung, eine weiterentwickelte Modulanordnung zum anwendungsspezifischen Aufbau von Blindleistungs-Kompensations-Filter- und Saugkreisanlagen in wahlweiser unverdrosselter, verdrosselter Schütz- oder Thyristor-geschalteter Ausführung zu realisieren,welche eine optimale Integration der einzelnen Systemkomponenten und eine Reduzierung der Einzelteile ermöglicht, so dass insgesamt kleinere, leichtere, sicherere und handlichere Anlagen schnell und kostengünstig realisiert werden können.

Die Lösung der Aufgabe der Erfindung erfolgt durch eine Modulanordnung gemäß der Merkmalskombination nach Patentanspruch 1, wobei die Unteransprüche zweckmäßige Ausgestaltungen und Weiterbildungen umfassen.

Es wird demnach von einer Modulanordnung zum anwendungsspezifischen Aufbau von Blindleistungs-Kompensations-Filter- und Saugkreisanlagen in wahlweiser unverdrosselter, verdrosselter Schütz- oder Thyristor-geschalteter Ausführung, umfassend Sammelschienensystem, Sicherungselemente, fingersicherer Abdeckung, Schaltgeräte, Drosseln und in der Leistung unterteilten Kondensatoren ausgegangen.

Erfindungsgemäß ist eine erste Moduleinheit mit einem ersten Abschnitt zur Aufnahme von Stromschienen, einer Stromschienen-/Sicherungsabdeckung und von Standard-Sicherungshaltern vorgesehen. Weiterhin besitzt die erste Moduleinheit einen zweiten, wannenartigen Abschnitt, wobei im wannenartigen Abschnitt Schaltmittel mechanisch fixierbar, elektrisch kontaktierbar und fingersicher aufgenommen sind.

Eine zweite Moduleinheit dient der Aufnahme eines oder mehrerer bevorzugt zwei Kondensatorwickelblöcke, wobei die zweite Moduleinheit den mindestens einen Kondensatorwickelblock isolierend umschließt.
Die erste und zweite Moduleinheit weisen jeweils einen Bodenbereich auf, wobei über Aussparungen oder Öffnungen im jeweiligen Bodenbereich mechanisch und/oder elektrische Verbindungen geführt sind, so dass entweder eine Rücken- an Rückenmontage mit direktem Andocken der ersten und zweiten Moduleinheit erfolgen kann oder alternativ ein kompakter Drosselsatz mit Anschlusselementen unter Nutzung der Aussparungen oder Öffnungen im jeweiligen Bodenbereich der ersten oder zweiten Moduleinheit zwischen diesen mechanisch aufgenommen und elektrisch anschließbar ist.

Der mindestens eine Kondensatorwickelblock besteht aus mindestens drei, selbstheilenden Einzelwickeln mit innerer Reihenschaltung, wobei in den Wickelkernrohren über deren Längsachsen verteilt, mehrere Temperatursicherungen so angeordnet sind, dass die kritischen Bereiche von jeweils zwei Wickeln von einer Temperatursicherung überwacht werden.

Die Sicherungen bilden mit einer gegen die Wickel isolierten, die Wickel ganz oder teilweise umschließenden, leitfähigen Umhüllung eine Reihenschaltung, um im Fehlerfall über den Steuerstromkreis eine allpolige Unterbrechung der äußeren Stromzuführung zum Kondensatorwickelblock zu bewirken.

Die Kondensatorwickelanschlüsse sind bei einer ausgestaltenen Ausführung über die zweite Moduleineinheit nach Außen geführt, um extern schaltbare Teilkapazitäten zu schaffen. Der interne Anschluss an die Kondensatorwickel und deren Verschaltung erfolgt Lötfrei, mittels neuartiger Federkraftkontaktierung durch ein federndes Material, kann aber auch durch Lötverbindung erfolgen.

In Kondensatoren nach dem Stand der Technik werden die Anschlüsse an die Wickel mittels Löt- oder Schweissverbindung hergestellt. Was wegen der hohen Löttemperaturen eine hohe Belastung für die Kondensatorfolie und wegen der Lötmittelrückstände eine zusätzliche Belastung für den Wickel darstellt und dadurch die Lebenserwartung des Kondensators beeinträchtigt.

Die erfindungsgemäße Anordnung umfasst weiterhin einen Drosselsatz, bestehend aus Einzeldrosseln, die jeweils Spulenkörper besitzen, welche Fortsätze mit Bohrung aufweisen, um über einen Durchgangsbolzen oder eine Durchgangsschraube eine Befestigung an der ersten und zweiten Moduleinheit zu ermöglichen, wobei der Bolzen oder die Schraube ergänzend innerhalb eines Hohlnietes, der die Drossel vor der Montage stabilisiert, im jeweiligen Drosselkern geführt ist.

Der zweite Abschnitt der ersten Moduleinheit dient der Aufnahme der Schaltschütze oder einer Leistungs- und Steuerungselektronik einschließlich notwendiger Kühlmittel, insbesondere eines Kühlkörpers.

An den jeweiligen Moduleinheiten sind Mittel zum Einschub in und zur Befestigung mittels Hutschiene ausgebildet.

Die Erfindung soll nachstehend anhand eines Ausführungsbeispiels sowie unter Zuhilfenahme von Figuren näher erläutert werden.

Hierbei zeigen:

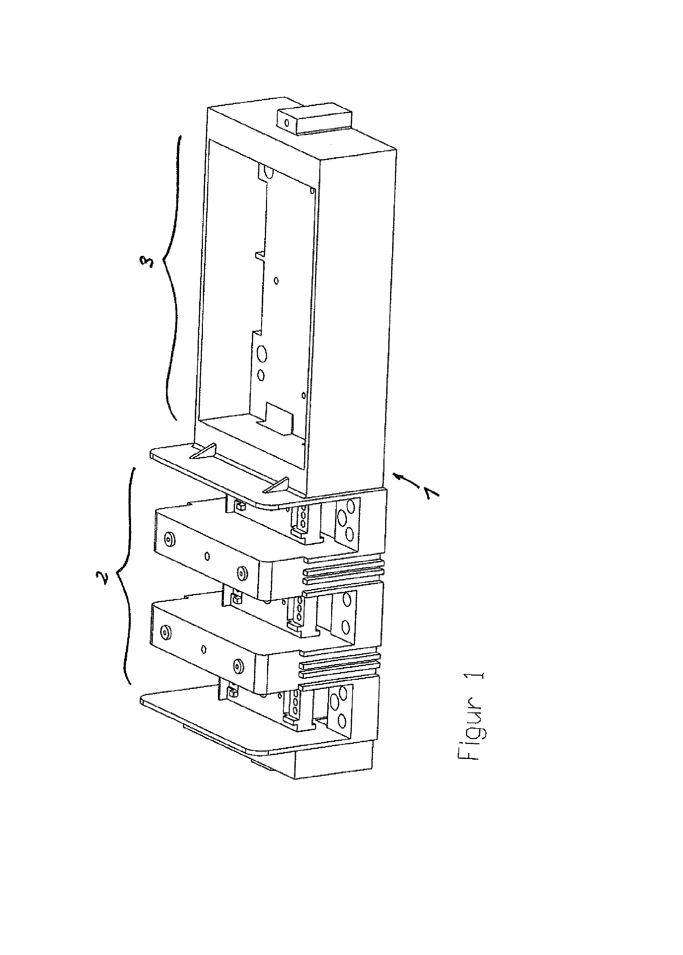

- Fig. 1: eine perspektivische Darstellung der ersten Moduleinheit; zur Aufnahme von Sammelschienen, Sicherungshaltern und Schaltgeräten

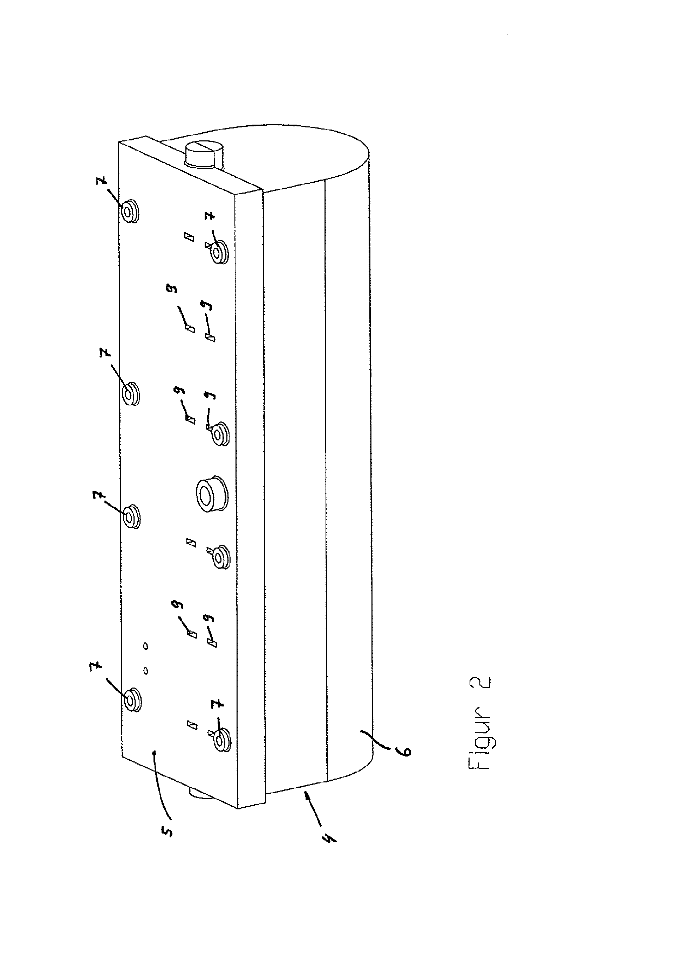

- Fig. 2: eine perspektivische Darstellung der zweiten Moduleinheit zur Aufnahme mindestens eines Kondensatorwickelblocks;
- Fig. 3.1 bis 3.4: (in der Reihenfolge von Fig. 3.1 bis 3.4) Ausführungsbeispiele realisierter Modulanordnungen ohne zwischengeschaltete Drosseln, mit Drosseln, regelbar im Beispiel in sechs Stufen a 8,33 kvar, mit Drosseln, regelbar im Beispiel in zwei Stufen a 25 kvar und regelbar in zwei Stufen ebenfalls a 25 kvar mit Leistungselektronik (dynamisch schaltend) und Kühlkörper innerhalb des zweiten wannenartigen Abschnitts der ersten Moduleinheit;
- Fig. 4: eine perspektivische Darstellung des Verbindungsspulenkörpers, der der Aufnahme der Wicklung, des Eisenkerns und der Fixierung der Jochbleche dient;
- Fig. 5: ein beispielhafter Drosselsatz in der Ausführung zweimal 25 kvar mit erkennbaren Bolzen bzw. Befestigungsschrauben;
- Fig. 6: eine Prinzipschnittdarstellung der Ausbildung einer Kondensatorwickelanordnung mit Schutzschleife, bestehend aus in Reihe geschalteten Temperatursicherungen TS und einer leitfähigen Folie und
- Fig. 7: eine spezielle Kondensatorschaltung mit angezapfter Filterkreisdrossel, wobei jeder Kondensatorwickel über eine Anzapfung für z.B. 8,33 und 16,66 Kvar verfügt, so dass zwei Teilleistungen mittels einem Wickelpaket erreichbar sind.

Die erfindungsgemäße Lösung gemäß den Figuren und dem Ausführungsbeispiel geht zunächst von einer ersten Moduleinheit 1 aus, die einen ersten Abschnitt 2 zur Aufnahme von Sammelschienensystem und Standardsicherungshaltern einschl. Abdeckung umfasst.

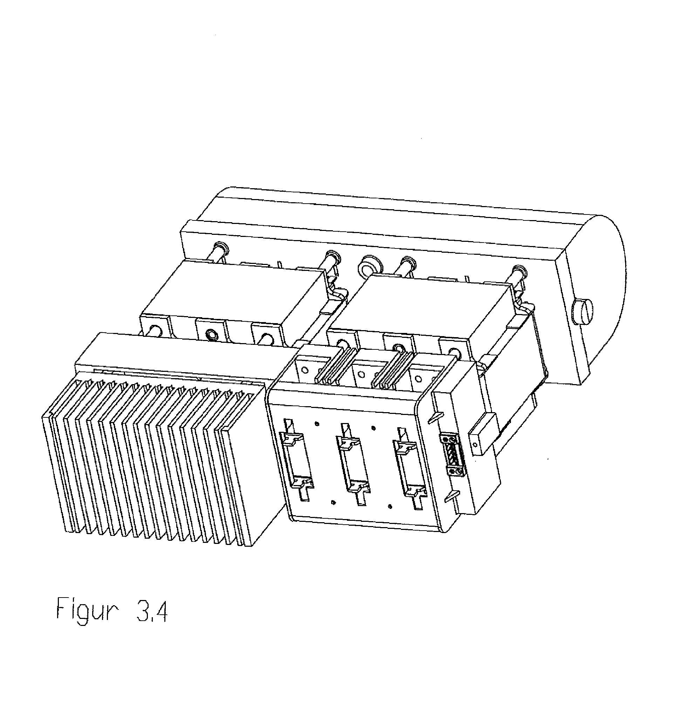

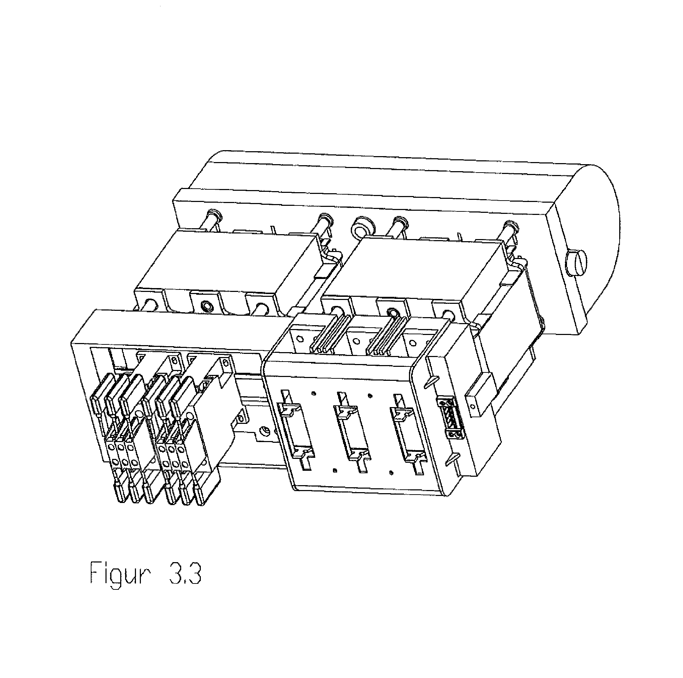

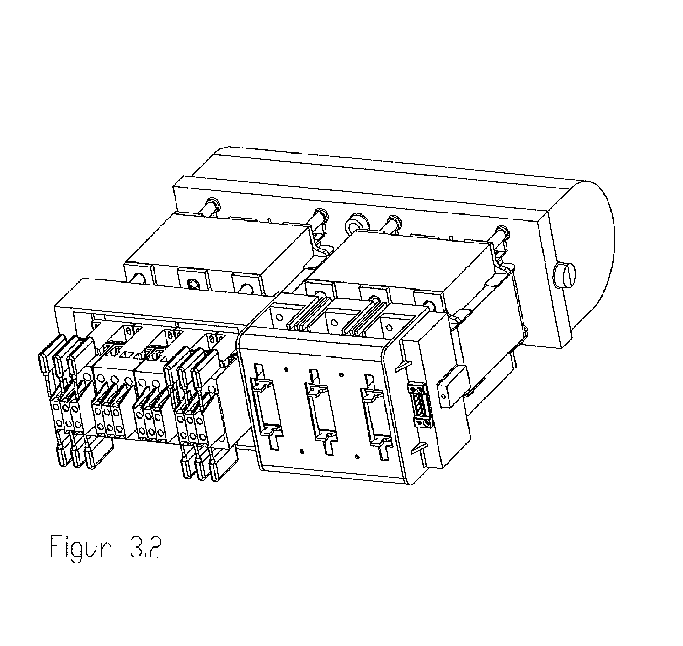

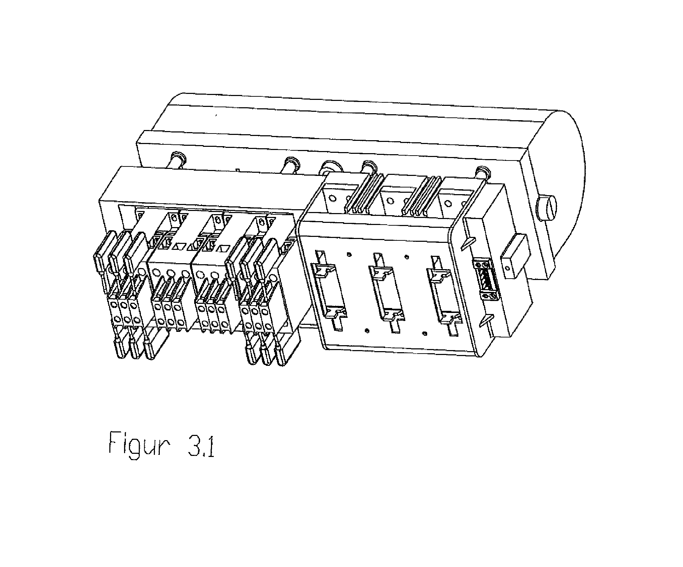

Diesem ersten Abschnitt 2 ist ein zweiter Abschnitt 3 benachbart, der wannenförmig ausgebildet ist. In dem wannenförmigen zweiten Abschnitt 3 können Schaltschütze oder eine Leistungselektronik nebst Kühlkörper zur dynamischen Schaltung, wie in Fig. 3 dargestellt, angeordnet werden.

Die erste Moduleinheit 1 besteht aus einem Kunststoffspritzguss- oder anderen Materialien mit entsprechenden isolierenden Eigenschaften. Die kammerartigen Abschnitte im ersten Abschnitt 2 dienen der Aufnahme von Standard Sicherungshaltern, sowie Sicherungen und besitzen Mittel zur Aufnahme von Stromschienen mit gleichzeitiger Stromschienen- und Sicherungsabdeckung.

Die zweite Moduleinheit 4 ist zur Aufnahme von einem oder mehreren Kondensatorwickelblöcken geeignet, und umschließt mindestens einen derartigen Wickelblock isolierend.

Die zweite Moduleinheit ist bevorzugt zweigeteilt, umfassend einen Bodenbereich 5 und eine isolierende Kappe (Kondensatorgehäuse) 6.

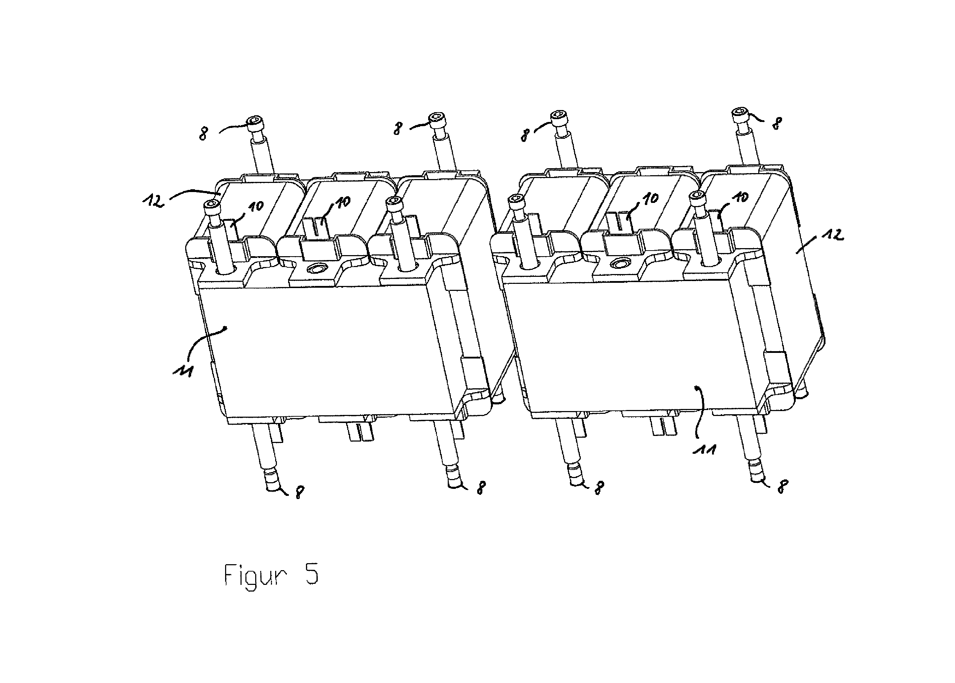

Im Bodenbereich 5 sind Bohrungen oder Durchführungen 7 enthalten, die zum Herstellen einer mechanischen elektrisch isolierten Verbindung mit der ersten Moduleinheit 1 dienen. Insbesondere können durch diese Bohrungen Schraubbolzen 8 (s. Fig. 5) aufgenommen werden, um einen Drosselsatz beidseitig isoliert zu fixieren. Weitere schlitzförmige Öffnungen 9 nehmen die elektrische Verbindungen (Anschlusslaschen) 10 zur Moduleinheit 1 oder zum Drosselsatz auf.

Bei einer ersten Ausführungsform der Erfindung ist eine Rücken- an Rückenmontage zwischen der ersten Moduleinheit 1 und der zweiten Moduleinheit 4 möglich, wie dies in der Fig. 3, obere Darstellung gezeigt ist. In dieser Darstellung nach Fig. 3 sind auch bereits NH-Sicherungselemente in Kammern des ersten Abschnitts 2 der ersten Moduleinheit 1 eingesetzt.

Erfindungsgemäß ist darüber hinaus ein kompakter Drosselsatz, wie in der Fig. 5 dargestellt.

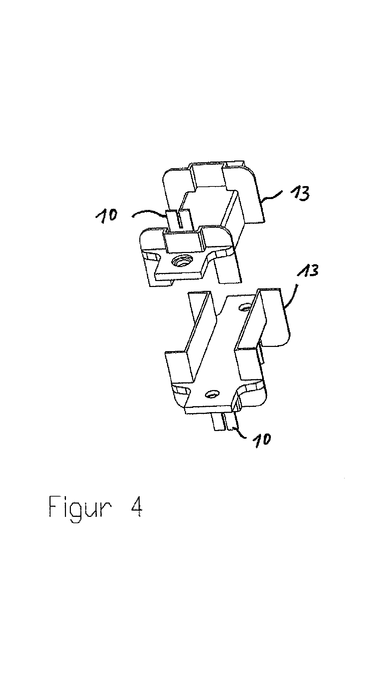

Der Drosselsatz umfasst jeweils einen Drosselkern 11 und Wicklungen 12. Ebenso sind Verbindungsspulenkörper 13 quasi als zwei Halbschalen vorhanden (s. Fig. 4). Der Drosselsatz mit Anschlusselementen kann unter Nutzung der Aussparungen oder Öffnungen 7/9 im jeweiligen Bodenbereich der ersten oder zweiten Moduleinheit zwischen diesen mechanisch aufgenommen, befestigt und elektrisch angeschlossen werden.

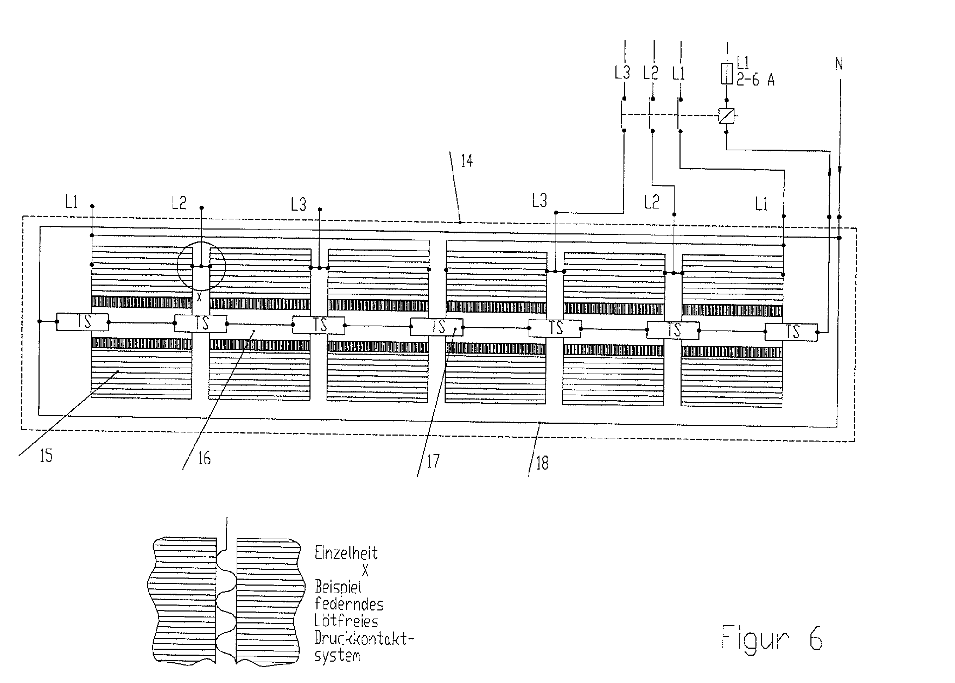

Der in der zweiten Moduleinheit 4 befindliche Kondensatorwickelblock kann beispielsweise so aufgebaut sein, wie dies die Prinzipdarstellung nach Fig. 6 offenbart.

In dem angedeuteten Kondensatorgehäuse 14 befinden sich mehrere Kondensatorenwickel 15. Die Kondensatorwickel sind auf Kernrohre 16 gewickelt.

Innerhalb des Kernrohres 16 befinden sich, Wickel zu Wickel überlappend, mehrere in Reihe geschaltete Temperatursicherungen 17, die in der Lage sind, beim Überschreiten einer vorgegebenen Grenztemperatur einen Stromkreis zu unterbrechen.

Ergänzend ist eine, gegen die Kondensatorwickel isolierte, Nullleiterrückführung als alle Kondensatorwickel, ganz oder teilweise, umhüllende leitfähige Folie oder Beschichtung 18 ausgebildet.

Hierdurch ist eine Sicherheitsschleife aus der Reihenschaltung von optimal platzierten Temperatursicherungen und der umhüllenden Folie realisiert derart, dass jeder Kondensatorwickel im Wickelkern und an den Kontaktierungen beidseitig temperaturüberwacht wird. Beim Aufschmelzen des Wickels erfolgt entweder ein Kurzschluss zu den auf N-Potential liegenden Temperatursicherungen oder zu der ebenfalls auf N-Potential liegenden leitfähigen umhüllenden Folie 18.

Ein Kurzschluss eines beliebigen Wickels oder eines beliebigen Außenleiters mit der Reihenschaltung Temperatursicherung-Umhüllungsfolie oder eine kritische Temperaturerhöhung an einem beliebigen Punkt der Sicherheitsschleife, führt entweder zum Ansprechen mindestens einer Temperatursicherung oder zum Ansprechen der vorgeschalteten Strom-Sicherung im Steuerstromkreis. Eine derartige Sicherung kann auch innerhalb des Kondensatorgehäuses, d. h. innerhalb der zweiten Moduleinheit angeordnet sein.

Der Ausfall einer Temperatursicherung oder ein innerer Kurzschluss mit zwangsweisem Steuersicherungsausfall führt also immer zum Abfallen (Abschalten) der Kondensatorschaltgeräte. Damit wird die Stromzufuhr zum Kondensator außerhalb des Kondensatorgehäuses mehrpolig im gezeigten Beispiel allpolig, nämlich dreiphasig sicher unterbrochen.

Hingegen wird bei Sicherheitskonzepten nach dem Stand der Technik bei Niederspannungs-Leistungskondensatoren die Stromzufuhr innerhalb des Kondensatorgehäuses unterbrochen, mit dem Nachteil, dass bei einer Reihe von Fehlerverläufen innere Kurzschlüsse, mit kritischen Wirkungen nach Außen, nicht auszuschließen sind und auf kritische Wickelaufschmelzungen und Temperaturerhöhungen erst über den Druckanstieg relativ spät reagiert wird. Eine gleichzeitige umfassende Überwachung von Temperatur und inneren Kurzschlüssen findet nicht statt.

Die Wickel des Kondensators können so gestaltet werden, dass beim dreiphasigen Drehstromsystem mit drei Wickeln zwei unterschiedliche oder zwei gleiche Drehstrom-Teilleistungen verfügbar sind. Dies ist mit der Herausführung von Anschlüssen der Wickel nach Fig. 6 symbolisiert.

Die in den Fig. 4 und 5 gezeigten Filterkreisdrosseln sind so gestaltet, dass sie zwischen Geräteträger und Kondensator mittels durchgehender Schrauben oder Bolzen, die durch Hohlnieten im Drosselkern geführt werden, magnetisch- und elektrisch isoliert befestigbar sind.

Damit stellen die Drosseln kein im Sinne des Standes der Technik eigenständiges Bauteil mehr dar, sondern sind ein verbindendes und tragendes Element zwischen der ersten und zweiten Moduleinheit.

Gemäß Ausführungsbeispiel ist vorgesehen, anstelle von Spulenkörper und Verbindungslaschen je Spule zwei baugleiche Verbindungsspulenkörper-Halbschalen 13 aus Isolierstoff auszubilden, die da zweiteilig, eine stufenlose Anpassung an unterschiedliche Kerntiefen (Drosselleistungen) gestatten und bekannte Spulenkörper und Verbindungslaschen so ersetzen, dass mit Hilfe der erwähnten Hohlniet-Schraubenverbindung die elektrischen und magnetischen Voraussetzungen dafür geschaffen werden, dass die Drossel als tragendes und verbindendes Element innerhalb der Modulanordnung nutzbar ist. Die Hauptstromverbindungen zwischen Schaltgeräten und Drosselblock bzw. zwischen Drossel- und Kondensatorblock kann auch steckbar erfolgen. Spulenkörper gemäß dem Stand der Technik verfügen nicht über Fortsätze mit Bohrungen und auch nicht über Aussparungen für Anschlusslaschen deshalb müssen zusätzlich sechs Verbindungslaschen zwischen oberen und unteren Jochblech angeordnet werden, auch können die Anschlusslaschen nicht punktgenau platziert werden.

Bekannte dreiphasige Filterkreisdrosseln verfügen in der Regel über eine Leistung von 25 kvar oder 50 kvar. Hierfür benötigen derartige Drosseln drei Wicklungen. Es sind auch Lösungen bekannt, bei welchen die Drosseln über zwei in der Regel gleiche Teilleistungen von z. B. 12,5 kvar oder 25 kvar verfügen. Hier sind üblicherweise sechs Einzel-Wicklungen zwischen zwei gemeinsamen Jochblechen erforderlich.

Die erfindungsgemäße Lösung kann von einer, z.B. 25 kvar Drossel mit 3 Wicklungen entweder die Gesamtinduktivität für Kondensatorleistungen von z.B. 8,33 kvar, 12,5 kvar bzw. 16,66 kvar oder die Teilinduktivität für die maximale Kondensatorleistung von z.B. 25 kvar abrufen. Hierdurch wird es möglich, z.B. mit nur zwei 25 kvar Drosseln mit je drei Wicklungen die Modulgesamtleistung von 50 kvar in sechs Schritten a 8,33 kvar (8,33:25) - (16,66:25) abzurufen. Dies stellt einen wesentlichen Vorteil im Sinne kleinerer Anlagen mit feinstufigen Regelungen dar.

Ab dem Anzapfungspunkt für die Teilinduktivität kann die Spule mit entsprechend schwächeren Querschnitt weiter gewickelt werden.

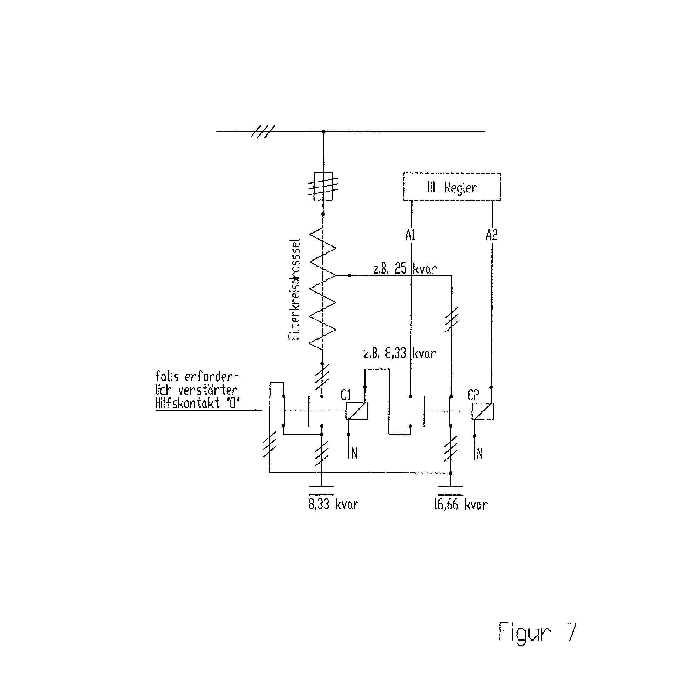

Eine Kondensatorschaltung mit angezapfter Filterkreisdrossel ist in der Fig. 7 gezeigt.

Um diese angezapften Drosseln und das System vor Überlastung und kritischen Induktivitätsverschiebungen zu schützen, ist sichergestellt, dass jeweils nur die Gesamtleistung der Drossel-Kondensator-Kombination, z. B. 25 kvar oder die jeweilige Teilleistung, z. B. 8,33 kvar, 12,5 kvar bzw. 16,66 kvar abgerufen und geschaltet werden kann. Dies wird mit der Verriegelungs- und Umschaltschützkombination nach Fig. 7 oder durch eine entsprechende Leistungselektronikschaltung erreicht. Kritische Schaltzustände werden über eine Softwareverriegelung des Blindleistungsreglers sicher ausgeschlossen.

Kondensatorschaltungen nach dem Stand der Technik verfügen nicht über diese Verriegelungs- und Umschaltkombination. Auch verfügen bekannte Blindleistungsregler nicht über eine solche Softwareverriegelung.

Dynamische Blindleistungs-Kompensationsanlagen werden mittels Thyristorschalter betrieben. Der Thyristorschalter ist bei bekannten Lösungen ein eigenständiges mehr oder weniger großes Bauteil, das getrennt auf einer Montageplatte montiert wird.

Bei der vorgestellten Lösung gemäß Fig. 3, untere Abbildungen, bildet der zweite, wannenartige Abschnitt der ersten Moduleinheit gleichzeitig das Gehäuse für die Leistungs- und Steuerungselektronik des Thyristorschalters und ist Träger des Hochleistungs-Kühlkörpers.

Die vorgestellte Modulanordnung ist erheblich leichter und kleiner als vergleichbare Leistungsmodule und kann durch ein einfaches Hutschienensystem mit Anschlag und Feder, schraubenlos befestigt werden. Eine aufwendige Verschraubung kann entfallen.

Die erläuterte Modulanordnung bildet ein neuartiges System zur Blindleistungs-Kompensation in hochintegrierter Form, in dem alle relevanten Bauteile sowohl von ihren elektrischen als auch konstruktiven Parametern optimal aufeinander abgestimmt sind. Einzelnen Bauteilen werden hier Doppelfunktionen zugewiesen, z. B. im Sinne einer mechanisch tragenden Funktion des Drosselsatzes und des Kondensators neben den innewohnenden elektrischen Parametern. Ergänzend ist das vorgestellte Kompensationssystem in der Lage, einen hohen Sicherheitsstandard zu gewährleisten bei gleichzeitig reduziertem Raumbedarf, kostengünstiger Herstellung und hoher Planungssicherheit.

Der Kondensatorblock sowie Sammelschienensystem mit Sicherungshaltern und Schaltgeräten wird nicht mehr, wie bisher aus diskreten eigenständigen Bauteilen und Kondensatoren aufgebaut, sondern stellt gemeinsam mit den Drosseln ein eigenständiges, integrales Produkt dar.

## Patentansprüche

1. Modulanordnung zum Aufbau von Blindleistungs-Kompensations-Filter- und Saugkreisanlagen in wahlweise unverdrosselter, verdrosselter Schütz- oder Thyristor-geschalteter Ausführung, umfassend ein Sammelschienensystem, Sicherungshalter, Schaltgeräte, mindestens eine Drossel und Leistungskondensatoren,
**dadurch gekennzeichnet, dass**
- eine erste Moduleinheit (1) mit einem ersten Abschnitt (2) zur Aufnahme von Stromschienen, Standardsicherungshaltern, Sicherungen, einer Stromschienenabdeckung als Stromschienen-Sicherungs-Berührungsschutz und einem zweiten, wannenartigen Abschnitt (3) vorgesehen ist, in dem Schaltgeräte oder Schaltmittel mechanisch fixierbar und elektrisch kontaktierbar aufgenommen sind, wobei die erste Moduleinheit (1) aus einem isolierenden Material besteht,
- eine zweite Moduleinheit (4) zur Aufnahme eines oder mehrerer, schaltbarer Kondensatorwickelblöcke ausgebildet ist, wobei die zweite Moduleinheit (4) den mindestens einen Wickelblock isolierend umschließt,
- die erste und zweite Moduleinheit (1; 4) jeweils einen Bodenbereich (5) aufweisen, wobei über Aussparungen oder Öffnungen (7; 9) im jeweiligen Bodenbereich (5) mechanische und/oder elektrische Verbindungen (10) geführt sind, so dass anwendungsspezifisch entweder eine Rücken- an Rückenmontage mit direktem Andocken der ersten und zweiten Moduleinheit erfolgen kann oder
- ein kompakter Drosselsatz mit Anschlusselementen unter Nutzung der Aussparungen oder Öffnungen (7; 9) im jeweiligen Bodenbereich (5) der ersten oder zweiten Moduleinheit (1; 4) zwischen diesen, elektrisch isoliert, mechanisch aufgenommen und elektrisch anschließbar ist und an der jeweiligen Moduleinheit (1; 4) Mittel zum Einschub in und zur schraublosen Befestigung an Hutschienen ausgebildet sind.

2. Anordnung nach Anspruch 1,
**dadurch gekennzeichnet, dass**
der Kondensatorwickelblock aus mindestens drei, bevorzugt sechs selbstheilenden Einzelwickeln (15) besteht, wobei in den Wickelkernrohren über deren Längsachse verteilt mehrere Temperatursicherungen (17) in Reihenschaltung so angeordnet sind, dass die kritischen Bereiche von jeweils zwei Wickeln, von einer gemeinsamen Temperatursicherung (17) überwacht werden und diese Sicherungen mit einer die Wickel ganz oder teilweise umschließenden, gegen die Wickel isolierten, leitfähigen Folie oder Beschichtung (18) eine Reihenschaltung bilden, um über den Steuerstromkreis im Fehlerfalle bei Übertemperatur oder innerem Kurzschluss eine allpolige Unterbrechung der äußeren Stromzuführung zum Kondensator und zum Wickelblock zu bewirken.

3. Anordnung nach Anspruch 2,
**dadurch gekennzeichnet, dass**
Kondensatorwickelanschlüsse über die zweite Moduleinheit (4) nach Außen geführt sind, um extern schaltbare Teilkapazitäten zu schaffen, wobei die zweite zum Kondensatorgehäuse gehörende Moduleinheit gleichzeitig isolierendes Trägerelement für die Drosseln oder die erste Moduleinheit ist.

4. Anordnung nach Anspruch 3,
**dadurch gekennzeichnet, dass**
die Anschlüsse an den Kondensatorwickel durch federnde Druckkontaktsysteme lötfrei realisiert sind.

5. Anordnung nach einem der vorangegangenen Ansprüche,
**dadurch gekennzeichnet, dass**
der Drosselsatz einzelne Drosseln umfasst, die jeweils Spulenkörper besitzen, welche jeweils mindestens einen Fortsatz mit Bohrung aufweisen, um über einen Durchgangsbolzen oder eine Durchgangsschraube (8) eine Befestigung an der ersten und zweiten Moduleinheit (1; 4) zu ermöglichen, wobei der Bolzen oder die Schraube ergänzend innerhalb eines Hohniets im jeweiligen Drosselkern geführt ist.

6. Anordnung nach Anspruch 5,
**dadurch gekennzeichnet, dass**
der Spulenkörper aus zwei baugleichen Halbschalen (13) besteht.

7. Anordnung nach einem der vorangegangenen Ansprüche,
**dadurch gekennzeichnet, dass**
die Funktionssicherheit der Kondensatoren durch eine wickelübergreifend platzierte Temperatursicherungskette in Reihenschaltung mit einer gegen die Wickel isolierten, diese ganz oder teilweise umfassenden, leitfähigen Folie oder leitfähigen Beschichtung realisiert wird, über die der Nullleiter der Schaltgeräte-Ansteuerung geführt ist, wobei bei Übertemperatur oder innerem Kurzschluss die Reihenschaltung unterbrochen und eine allpolige Trennung des oder der Kondensatoren vom Netz erfolgt.

8. Anordnung nach einem der vorangegangenen Ansprüche,
**dadurch gekennzeichnet, dass** jede Wicklung einer Drossel neben einem Anschluss oder Ausgang für die Gesamtinduktivität für eine kleinere Kondensatorleistung über eine Anzapfung einer Teilinduktivität für eine größere Kondensatorleistung verfügt, wobei durch eine Verriegelungs-Umschaltung mittels der Schaltgeräte sichergestellt ist, dass bedarfsweise entweder nur die Teilinduktivität oder die Gesamtinduktivität mit Kondensatoren beschaltet wird.

9. Anordnung nach einem der vorangegangenen Ansprüche,
**dadurch gekennzeichnet, dass**
der zweite Abschnitt (3) der ersten Moduleinheit (1) der Aufnahme der Schaltgeräte oder einer Leistungs- und/oder Steuerungselektronik einschließlich Kühlkörper hierfür dient.

## Claims

1. A module arrangement for constructing power factor correction, filter and drain circuit systems in either unthrottled or throttled protection-switched or thyristor-switched embodiment, comprising a busbar system, fuse holder, switching devices, at least one throttle, and power capacitors,
**characterized in that**
- a first module unit (1) is provided with a first section (2) for accommodating busbars, standard fuse holders, fuses, a busbar cover as a busbar-fuse touch safeguard and a second, trough-like section (3), in which switching devices or switching means are accommodated so they can be mechanically fixed and electrically contacted, wherein the first module unit (1) consists of an insulating material,
- a second module unit (4) is designed to accommodate one or more switchable capacitor winding blocks, wherein the second module unit (4) encloses the at least one winding block in an insulating manner,
- the first and second module units (1; 4) each have a base region (5), wherein mechanical and/or electrical connections (10) are led via recesses or openings (7; 9) in the respective base region (5), so that, in an application-specific manner, either back-to-back mounting with direct docking of the first and second module units can be performed or
- a compact throttle set having terminal elements can be electrically insulated, mechanically accommodated, and electrically connected, while using the recesses or openings (7; 9) in the respective base region (5) of the first or second module unit (1; 4), between these module units, and means for inserting in and screw-free fastening on top-hat rails are formed on the respective module unit (1; 4).

2. The arrangement according to Claim 1,
**characterized in that** the capacitor winding block consists of at least three, preferably six self-healing individual windings (15), wherein multiple thermal cutoffs (17) are arranged in a series circuit in the winding core tubes, distributed over the longitudinal axis thereof, so that the critical regions of each two windings are monitored by a shared thermal cutoff (17) and these cutoffs form a series circuit with a conductive film or coating (18), which entirely or partially encloses the winding and is insulated from the winding, to cause a disconnection at all terminals of the external power supply to the capacitor and to the winding block via the control power circuit in case of fault in the event of excess temperature or internal short-circuit.

3. The arrangement according to Claim 2,
**characterized in that** capacitor winding terminals are led outward via the second module unit (4), to provide externally switchable partial capacitors, wherein the second module unit associated with the capacitor housing is simultaneously the insulating carrier element for the throttles or the first module unit.

4. The arrangement according to Claim 3,
**characterized in that** the terminals on the capacitor winding are implemented in a solder-free manner by springy pressure contact systems.

5. The arrangement according to any one of the preceding claims,
**characterized in that** the throttle set comprises individual throttles, which each have coil bodies, which each have at least one extension having borehole, to enable fastening to the first and second module units (1; 4) via a through pin or a through screw (8), wherein the pin or the screw is additionally guided inside a hollow rivet in the respective throttle core.

6. The arrangement according to Claim 5,
**characterized in that** the coil body consists of two structurally-equivalent half shells (13).

7. The arrangement according to any one of the preceding claims,
**characterized in that** the functional reliability of the capacitors is implemented by a thermal cutoff chain, which is placed in a winding-encompassing manner, in series circuit with a conductive film or conductive coating, which is insulated from the winding and entirely or partially encloses it, via which the neutral conductor of the switching device controller is guided, wherein in the event of excess temperature or interior short-circuit, the series circuit is interrupted and a disconnection at all terminals of the capacitor or capacitors from the grid takes place.

8. The arrangement according to any one of the preceding claims,
**characterized in that** each winding of a throttle, in addition to a terminal or output for the total inductance for a lesser capacitor power, has a tap of a partial inductance for a greater capacitor power, wherein it is ensured by a locking switchover by means of the switching devices that if needed either only the partial inductance or the total inductance is interconnected with capacitors.

9. The arrangement according to any one of the preceding claims,
**characterized in that** the second section (3) of the first module unit (1) is used to accommodate the switching devices or power and/or control electronics, including heat sinks for this purpose.

## Revendications

1. Agencement modulaire pour constituer des installations à filtre de compensation de puissance réactive et des installations à circuit d'absorption, en réalisation au choix filtrée ou non-filtrée, commutées par contacteur ou par thyristor, comportant un système de barres collectrices, de porte-fusibles, d'appareils de commutation, au moins une bobine d'arrêt et des condensateurs de puissance,
**caractérisé en ce que**
- il est prévu une première unité modulaire (1) avec une première portion (2) destinée à recevoir des rails conducteurs, des porte-fusibles standard, des fusibles, un recouvrement de rail conducteur à titre de protection contre les contacts avec le rail conducteur et les fusibles, ainsi qu'une seconde portion (3) en forme de cuve dans laquelle sont reçus des appareils de commutation ou des moyens de commutation de manière à pouvoir être fixés mécaniquement et être contactés électriquement, la première unité modulaire (1) étant constituée en un matériau isolant,
- il est prévu une seconde unité modulaire (4) pour recevoir un ou plusieurs blocs bobinés formant condensateurs commutables, la seconde unité modulaire (4) entourant avec isolement ledit au moins un bloc bobiné,
- la première et la seconde unités modulaires (1 ; 4) présentent chacune une zone de fond (5), des liaisons mécaniques et/ou électriques (10) étant menées à travers des échancrures ou des ouvertures (7 ; 9) dans la zone de fond respective (5), de sorte que, en fonction de l'application, soit un montage dos-à-dos avec accolement direct de la première et de la seconde unité modulaire peut se faire, soit
- un lot compact de bobines d'arrêt avec des éléments de connexion est disposé en utilisant les échancrures ou les ouvertures (7 ; 9) dans la zone de fond respective (5) de la première ou de la seconde unité modulaire (1 ; 4), qui est reçu entre celles-ci en étant isolé électriquement, reçu mécaniquement et susceptible d'être raccordé électriquement, et **en ce qu'**il est prévu des moyens sur l'unité modulaire respective (1 ; 4), destinés à être insérés dans des rails chapeaux et à être fixés sans vissage sur ceux-ci.

2. Agencement selon la revendication 1,
**caractérisé en ce que**
le bloc bobiné formant condensateur est constitué par au moins trois, de préférence six bobines individuelles (15) auto-réparatrices, plusieurs disjoncteurs thermiques (17) étant agencés en circuit série dans les tubes formant noyau d'enroulement en étant répartis sur leur axe longitudinal, de telle sorte que les zones critiques de deux enroulements respectifs sont surveillées par un disjoncteur thermique (17) commun, et que ces disjoncteurs forment un circuit série avec une feuille ou une couche de revêtement (18) conductrice entourant complètement ou partiellement les enroulements et isolée vis-à-vis des enroulements, pour provoquer une interruption sur tous les pôles de l'alimentation électrique extérieure vers le condensateur et vers le bloc bobiné via le circuit électrique de commande, en cas d'erreur lors d'une température excessive ou lors d'un court-circuit intérieur.

3. Agencement selon la revendication 2,
**caractérisé en ce que**
des bornes de connexion d'enroulements condensateurs sont menées vers l'extérieur par la seconde unité modulaire (4), afin de créer des capacités partielles à commuter par voie externe, et la seconde unité modulaire faisant partie du boîtier condensateur est simultanément un élément de support isolant pour les bobines d'arrêt ou pour la première unité modulaire.

4. Agencement selon la revendication 3,
**caractérisé en ce que**
les bornes de connexion sont réalisées sans brasage sur l'enroulement condensateur par des systèmes de contact de compression à effet ressort.

5. Agencement selon l'une des revendications précédentes,
caractérisé ce que
le lot de bobines d'arrêt inclut des bobines individuelles qui possèdent chacune des corps d'enroulement qui présentent au moins un prolongement pourvu d'un perçage afin de permettre une fixation sur la première ou sur la seconde unité modulaire (1 ; 4) par un boulon traversant ou par une vis traversante (8), le boulon ou la vis étant mené(e) en complément à l'intérieur d'un rivet creux dans le noyau de bobine respectif.

6. Agencement selon la revendication 5,
**caractérisé en ce que**
le corps de bobine est constitué par deux demi-coques (13) de structure identique.

7. Agencement selon l'une des revendications précédentes,
**caractérisé en ce que**
la sécurité de fonctionnement des condensateurs est réalisée par une chaîne de disjoncteurs thermiques placée de manière à coiffer les enroulements et agencée en circuit série avec une feuille conductrice ou une couche de revêtement conductrice, isolée vis- à-vis des enroulements en les entourant complètement ou partiellement, via laquelle est mené le conducteur neutre de la commande des appareils de commutation, et en cas de température excessive ou lors d'un court-circuit interne, le circuit série est interrompu et une séparation du ou des condensateurs vis-à-vis du réseau s'effectue sur tous les pôles.

8. Agencement selon l'une des revendications précédentes,
**caractérisé en ce que** chaque enroulement d'une bobine d'arrêt dispose, outre une borne ou une sortie pour l'inductivité globale pour une puissance de condensateur plus petite, d'une prise d'une inductivité partielle pour une puissance de condensateur plus importante, et grâce à une commutation de verrouillage au moyen des appareils de commutation, il est assuré qu'en cas de besoin soit l'inductivité partielle soit l'inductivité globale est mise en circuit avec les condensateurs.

9. Agencement selon l'une des revendications précédentes,
**caractérisé en ce que**
la seconde portion (3) de la première unité modulaire (1) sert à recevoir les appareils de commutation ou une électronique de puissance et/ou de commande, y compris le corps de refroidissement.
